# EUROPEAN PATENT APPLICATION

(11) **EP 4 496 012 A1**
(43) Date of publication of application: **22.01.2025**
(21) Application number: 24184250.9
(22) Date of filing: 25.06.2024
(51) Int. Cl.: H01L 33/06, H01L 33/14, H01L 33/32

(54) **NITRIDE SEMICONDUCTOR LIGHT EMITTING ELEMENT AND METHOD OF MANUFACTURING SAME**

(30) Priority: 27.06.2023 JP 2023105182
(71) Applicant: Nichia Corporation, Anan-shi, Tokushima 774-8601 (JP)
(72) Inventor: OKADA, Takuya, Anan-shi, Tokushima, 774-8601 (JP)
(74) Representative: Betten & Resch

(57) **Abstract**

A nitride semiconductor light emitting element includes: an n-side semiconductor layer; a p-side semiconductor layer; an active layer positioned between the n-side semiconductor layer and the p-side semiconductor layer; and an electron blocking layer positioned between the p-side semiconductor layer and the active layer. The active layer includes, successively from the n-side semiconductor layer side: a first barrier layer containing Al, a first well layer that contains Al and emits ultraviolet light, a second barrier layer containing Al, and a second well layer that is in contact with the electron blocking layer, contains Al, and emits ultraviolet light. An Al composition ratio of the second well layer is higher than an Al composition ratio of the first well layer. A thickness of the second well layer is less than a thickness of the first well layer.

## Description

### CROSS-REFERENCE TO RELATED APPLICATION

This application claims priority to Japanese Patent Application No. 2023-105182, filed above June 27, 2023, the disclosure of which is hereby incorporated by reference in its entirety.

### TECHNICAL FIELD

The present disclosure relates to a nitride semiconductor light emitting element and a method of manufacturing the same.

### BACKGROUND

The development of a nitride semiconductor light emitting element that emits ultraviolet light has been in progress. For example, Japanese Patent Publication No. H09-153645 discloses a light emitting element having an emission layer that emits ultraviolet light.

### SUMMARY

There is room for improvement in terms of the light emission efficiency of a nitride semiconductor light emitting element that emits ultraviolet light as compared to a light emitting element that emits visible light.

One object of the present disclosure is to provide a nitride semiconductor light emitting element that emits ultraviolet light with an improved light emission efficiency and a method of manufacturing the same.

A nitride semiconductor light emitting element according to the present disclosure is a light emitting element comprising an n-side semiconductor layer, a p-side semiconductor layer, an active layer positioned between the n-side semiconductor layer and the p-side semiconductor layer, and an electron blocking layer between the p-side semiconductor layer and the active layer, wherein:
the active layer includes, successively from the n-side semiconductor layer side, a first barrier layer containing Al, a first well layer containing Al and emitting ultraviolet light, a second barrier layer containing Al, and a second well layer disposed in contact with the electron blocking layer, containing Al, and emitting ultraviolet light,
the Al composition ratio of the second well layer is higher than the Al composition ratio of the first well layer, and
the thickness of the second well layer is less than the thickness of the first well layer.

A method of manufacturing a nitride semiconductor light emitting element according to the present disclosure includes
forming an n-side semiconductor layer,
forming an active layer above the n-side semiconductor layer, and
forming a p-side semiconductor layer above the active layer, in which the step of forming an active layer includes:
   forming above the n-side semiconductor layer a first barrier layer containing Al;
   forming above the first barrier layer a first well layer containing Al and emitting ultraviolet light;
   forming above the first well layer a second barrier layer containing Al; and
   forming above the second barrier layer a second well layer containing Al at a higher Al composition ratio than that of the first well layer, lesser in thickness than the first well layer, and emitting ultraviolet light,
   the method including forming an electron blocking layer in contact with the second well layer after forming the active layer but before forming the p-side semiconductor layer.

According to an embodiment of the present disclosure, a nitride semiconductor light emitting element that emits ultraviolet light with high light emission efficiency and a method of manufacturing the same can be provided.

### BRIEF DESCRIPTION OF THE DRAWINGS

FIG. 1 is a cross-sectional view showing the constituents of a nitride semiconductor light emitting element according to one embodiment of the present disclosure.
FIG. 2 is a diagram showing the structure of the active layer and the electron blocking layer of the nitride semiconductor light emitting element shown in FIG. 1.
FIG. 3 is a cross-sectional view showing an underlayer formed above the upper face of a substrate in a method of manufacturing a light emitting element according to one embodiment of the present disclosure.
FIG. 4 is a cross-sectional view showing a superlattice layer formed above the underlayer shown in FIG. 3 in the method of manufacturing a light emitting element according to the embodiment of the present disclosure.
FIG. 5 is a cross-sectional view showing an n-side semiconductor layer formed above the superlattice layer shown in FIG. 4 in the method of manufacturing a light emitting element according to the embodiment of the present disclosure.
FIG. 6 is a cross-sectional view showing an active layer formed above the n-side semiconductor layer shown in FIG. 5 in the method of manufacturing a light emitting element according to the embodiment of the present disclosure.
FIG. 7 is a cross-sectional view showing an electron blocking layer formed above the active layer shown in FIG. 6 in the method of manufacturing a light emitting element according to the embodiment of the present disclosure.
FIG. 8 is a cross-sectional view showing a p-side semiconductor layer formed above the electron blocking layer shown in FIG. 7 in the method of manufacturing a light emitting element according to the embodiment of the present disclosure.

### DETAILED DESCRIPTION

Certain embodiments and examples of the present disclosure will be explained below with reference to the accompanying drawings. The light emitting elements and the methods of manufacturing light emitting elements described below are provided to give shape to the technical ideas of the present disclosure, and do not limit the invention unless otherwise specifically stated.

In the drawings, the same reference numerals denote members having the same functions. To make the features easily understood, the descriptions of the features are distributed among the embodiments and examples, but the constituent elements described in different embodiments can be replaced or combined in part. The explanation of common features already described in embodiments appearing earlier might be omitted in the subsequent embodiments where the explanation is focused only above the differences. The same or similar effects attributable to the same or similar features, in particular, will not be mentioned each time an embodiment or example is discussed. The sizes of and positional relationships between the members shown in each drawing might be exaggerated for clarity of explanation. For example, the drawings accompanying the present specification are primarily schematic diagrams showing the stacked structures, and do not necessarily accurately reflect the thickness of each layer.

### EMBODIMENT

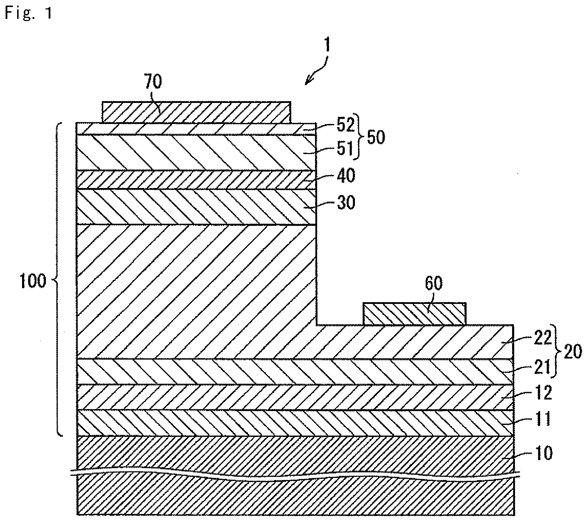

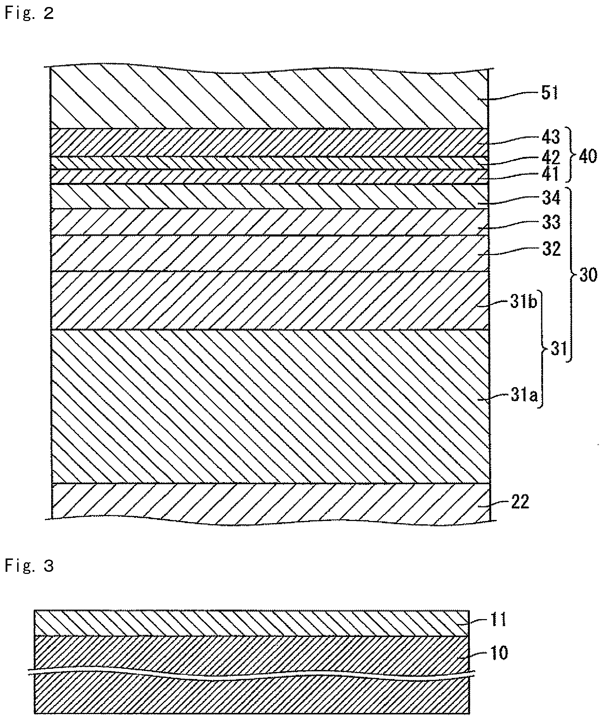

FIG. 1 is a schematic cross-sectional view of a nitride semiconductor light emitting element 1 according to an embodiment. FIG. 2 is a schematic cross-sectional view enlarging the active layer 30 and the electron blocking layer 40 that are parts of a semiconductor structure body 100.

As shown in FIG. 1 and FIG. 2, the nitride semiconductor light emitting element 1 includes a substrate 10 and a semiconductor structure body 100 disposed above the substrate 10. The semiconductor structure body 100 includes an n-side semiconductor layer 20, a p-side semiconductor layer 50, and an active layer 30 positioned between the n-side semiconductor layer 20 and the p-side semiconductor layer 50 and emitting ultraviolet light, each formed of a nitride semiconductor. The semiconductor structure 100 also includes an underlayer 11 and a superlattice layer 12 positioned between the substrate 10 and the n-side semiconductor layer 20, and an electron blocking layer 40 positioned between the active layer 30 and the p-side semiconductor layer 50. The nitride semiconductor light emitting element 1 has an n-electrode 60 electrically connected to the n-side semiconductor layer 20 and a p-electrode 70 electrically connected to the p-side semiconductor layer 50.

Here, the active layer 30 includes, successively from the n-side semiconductor 20 side, a first barrier layer 31 containing Al, a first well layer 32 containing Al and emitting ultraviolet light, a second barrier layer 33 containing Al, and a second well layer 34 containing Al and emitting ultraviolet light, in which the second well layer 34 is in contact with the electron blocking layer 40.

The Al composition ratio of the second well layer 34 is higher than the Al composition ratio of the first well layer 32, and the thickness of the second well layer 34 is less than the thickness of the first well layer 32.

According to the nitride semiconductor light emitting element of the embodiment structured as above, a nitride semiconductor light emitting element with improved ultraviolet light emission efficiency can be achieved.

The substrate 10 and each semiconductor layer will be specifically described below.

In the description below, the constituents excluding the active layer 30 will be described before describing the active layer 30 in detail.

For the material for the substrate 10, for example, sapphire, silicon (Si), gallium nitride (GaN), aluminum nitride (AlN), or the like can be used. A substrate 10 formed of sapphire is preferable, as it has a high transmittance with respect to the ultraviolet light from the active layer 30. The semiconductor structure body 100 can be disposed, for example, above C-plane of the sapphire substrate, and is preferably disposed above a face oblique to the C-plane of the sapphire substrate forming a 0.2 to 2 degree angle with the a-axis or the m-axis of the sapphire substrate. The thickness of the substrate 10 can be set, for example, in a range of 150 *µ*m to 800 *µ*m. The nitride semiconductor light emitting element 1 does not have to have a substrate 10.

A semiconductor structure body 100 is a stack structure in which nitride semiconductor layers are stacked. The nitride semiconductor can be any semiconductor obtained by varying the composition ratio x and y within their ranges in the chemical formula InₓAl_{y}Ga_{1-x-y}N (0≤x≤1, 0≤y≤1, x+y≤1).

For an underlayer 11, for example, a layer formed of AlN can be used. The underlayer 11 functions to reduce lattice mismatch between the substrate 10 and the nitride semiconductor layers disposed above the underlayer 11. The thickness of the underlayer 11 can be set, for example, in a range of 0.5 *µ*m to 4 *µ*m, preferably 1.5 *µ*m to 4 *µ*m. The underlayer 11 may include a buffer layer, and the buffer layer is located near the surface of the substrate 10. In the present specification, the thickness of each semiconductor layer refers to the thickness in the stacking direction of the semiconductor structure body 100.

A superlattice layer 12 may be, for example, a multilayer structure in which first semiconductor layers and second semiconductor layers having a different lattice constant from that of the first semiconductor layers are alternately formed. The superlattice layer 12 has the function of reducing the stress occurring in the semiconductor layers disposed above the superlattice layer 12. The superlattice layer 12 can be a multilayer structure in which AlN layers and aluminum gallium nitride (AlGaN) layers are alternately stacked. The number of pairs of first and second semiconductor layers in the superlattice layer 12 can be set to 20 to 50 pairs. In the case in which the first semiconductor layers are AlGaN and the second semiconductor layers are AlN layers, for example, the first semiconductor layers can be 5 nm to 30 nm in thickness, and the second semiconductor layers can be 5 nm to 30 nm in thickness.

An n-side semiconductor layer 20 includes one or more n-type semiconductor layers. Examples of n-type semiconductor layers include semiconductor layers containing an n-type impurity, such as silicon (Si), germanium (Ge), or the like. An n-type semiconductor layer is, for example, an AlGaN layer containing aluminum (Al), gallium (Ga), and nitrogen (N), and may contain indium (In). For example, the n-type impurity concentration of an n-type semiconductor layer containing Si as an n-type impurity is in a range of 5 × 10¹⁸ /cm³ to 1×10²⁰ /cm³. The n-side semiconductor layer 20 has only to have the function of supplying electrons to the active layer 30, and may include an undoped layer. Here, an undoped layer is a layer not intentionally doped with an n-type impurity or a p-type impurity. In the case where an undoped layer is adjacent to a layer intentionally doped with an n-type impurity and/or a p-type impurity, the undoped layer might contain the n-type impurity and/or the p-type impurity diffused from the adjacent layer.

As shown in FIG. 1, the n-side semiconductor layer 20 includes, for example, an undoped layer 21 and an n-side contact layer 22. The undoped layer 21 is disposed between the superlattice layer 12 and the n-side contact layer 22. The n-side contact layer 22 is disposed between the undoped layer 21 and the active layer 30.

For the undoped layer 21, for example, an undoped AlGaN layer can be used. In the case of using an AlGaN layer as the undoped layer 21, the Al composition ratio of the AlGaN layer can be set, for example, in a range of 25% to 70%.

For the n-side contact layer 22, for example, a layer formed of AlGaN and containing an n-type impurity can be used. In the case of using an AlGaN layer as the n-side contact layer, the Al composition ratio of the AlGaN layer can be set, for example, to 25% to 70%. In the present specification, an AlGaN layer having an Al composition ratio of 50%, for example, means that the composition ratio x in the chemical formula Al_{X}Ga_{1-X}N is 0.5. The n-type impurity concentration of the n-side contact layer 22 can be set, for example, in a range of 5×10¹⁸ /cm³ to 1×10²⁰ /cm³. The thickness of the n-side contact layer 22 is preferably greater than the thickness of the undoped layer 21. Making the n-side contact layer 22 thicker than the undoped layer 21 can reduce the forward voltage increase. The thickness of the n-side contact layer 22 can be set, for example in a range of 1.5 *µ*m to 4 *µ*m. The n-side contact layer 22 has an upper face above which no semiconductor layer is disposed. An n-electrode 60 is disposed above a portion of the upper face of the n-side contact layer 22 above which no semiconductor layer is disposed.

An electron blocking layer 40 is a layer for reducing the overflow of electrons supplied from the n-side semiconductor layer 20. For the electron blocking layer 40, a nitride semiconductor layer having a relatively large band gap is preferably used. For example, in the case in which the second well layer 34 that is in contact with the electron blocking layer 40 is formed of a nitride semiconductor layer containing Al as described later, a nitride semiconductor layer having a higher Al content than that of the second well layer 34 can be used as the electron blocking layer 40. The electron blocking layer 40 may include multiple layers. For example, the electron blocking layer 40 can be a multilayer structure having, successively from the active layer 30 side, a first electron blocking layer 41, a second electron blocking layer 42, and a third electron blocking layer 43 as shown in FIG. 2. For example, each of the first electron blocking layer 41, the second electron blocking layer 42, and the third electron blocking layer 43 contains Al. For example, the first electron blocking layer 41 can be an AlN layer, the second electron blocking layer 42 an AlGaN layer, and the third electron blocking layer 43 an AlGaN layer. In this specific example, the Al composition ratio of the second electron blocking layer 42 is lower than the Al composition ratio of the third electron blocking layer 43. Moreover, the Al composition ratio of the second electron blocking layer 42 is higher than the Al composition ratio of the first well layer 32 and the Al composition ratio of the second well layer 34. In the electron blocking layer 40 in this specific example, the second electron blocking layer 42 and the third electron blocking layer 43 preferably have a higher Al composition ratio than the Al composition ratio of the second barrier layer 33, for example. This can reduce electron overflow. For the electron blocking layer 40, for example, an undoped AlGaN layer, an undoped AlN layer, or the like can be used. The total thickness of the electron blocking layer 40 can be set, for example, in a range of 4 nm to 15 nm.

A p-side semiconductor layer 50 preferably has a high transmittance with respect to the light from the first well layer 32 and the second well layer 34. For example, the p-side semiconductor layer 50 preferably includes an AlGaN layer having a higher Al composition ratio than the Al composition ratios of the first well layer 32 and the second well layer 34. However, an AlGaN layer having a high Al composition ratio has a larger band gap than that of a GaN layer or the like. For this reason, employing an AlGaN layer having a high Al composition ratio as a p-side semiconductor layer 50 tends to result in inadequate conversion of the p-side semiconductor layer 50 into a p-type layer or an increased contact resistance between the p-electrode 70 and the p-side semiconductor layer 50. Thus, for a nitride semiconductor light emitting element using an AlGaN layer having a relatively high Al composition ratio as the first well layer 32 and the second well layer 34, it is necessary to achieve both high light extraction efficiency and low forward voltage. This embodiment makes it possible to achieve a nitride semiconductor light emitting element 1 with high light extraction efficiency and low forward voltage by employing the p-side semiconductor layer 50 described below.

For example, in this embodiment, the p-side semiconductor layer 50 includes, as shown in FIG. 1, a first p-side semiconductor layer 51 and a second p-side semiconductor layer 52. Here, the first p-side semiconductor layer 51 is a layer containing a p-type impurity such as magnesium (Mg) and having a high Al composition ratio, and the second p-side semiconductor layer 52 is a layer containing a p-type impurity such as magnesium (Mg) and having a low Al composition ratio, or containing no Al (e.g., GaN layer). Including such a first p-side semiconductor layer 51 and a second p-side semiconductor layer 52 can achieve a nitride semiconductor light emitting element 1 having high light extraction efficiency and low forward voltage Vf.

Furthermore, the first p-side semiconductor layer 51 and the second p-side semiconductor layer 52 may be of a single layer or one including multiple layers. For example, the first p-side semiconductor layer 51 may include, successively from the active layer 30 side, a first layer formed of AlGaN, a second layer formed of AlGaN with a lower Al composition ratio than that of the first layer, and a third layer formed of AlGaN with a lower Al composition ratio than that of the second layer. In this case, the third layer may be a gradient composition layer in which the Al composition ratio gradually decreases. The second p-side semiconductor layer 52 may include, for example, from the first p-side semiconductor layer 51 side, a fourth layer formed of AlGaN and a fifth layer formed of GaN. Including first to fifth layers as described above can achieve a nitride semiconductor light emitting element 1 having higher light extraction efficiency and lower forward voltage Vf.

An n-electrode 60 is disposed above the n-side contact layer 22 and electrically connected to the n-side semiconductor layer 20. A p-electrode 70 is disposed above the second p-side semiconductor layer 52 of the p-side semiconductor layer 50 and electrically connected to the p-side semiconductor layer 50.

For the n-electrode 60, for example, metals, such as Ag, Al, Ni, Au, Rh, Ti, Pt, Mo, Ta, W, and Ru, or alloys containing these metals as main components can be used. The n-electrode 60 can be a multilayer structure including, successively from the n-side contact layer 22 side, a Ti layer, an Al alloy layer, a Ta layer, and a Ru layer, for example.

For the p-electrode 70, for example, the same or similar metal to that for the n-electrode 60 described above can be used. In the case of allowing the p-electrode 70 to have the function to reflect the light from the active layer 30 that is advancing to the p-electrode 70 towards the n-side semiconductor layer 20, the metal layer among those in the p-electrode 70 that is disposed in contact with the third layer 53 is preferably formed of a metal having a high reflectance with respect to the light from the active layer 30. For example, the metal layer preferably has, for example, a reflectance of 70% or higher, more preferably 80% or higher, with respect to the light from the active layer 30. For such a metal layer, for example, a Rh layer or Ru layer is preferably used. The p-electrode 70 can be a multilayer structure that includes, for example, a Rh layer, an Au layer, a Ni layer, and a Ti layer, or a multilayer structure that includes a Ru layer, an Au layer, a Ni layer and a Ti layer.

When a forward voltage is applied across the n-electrode 60 and the p-electrode 70, a forward voltage applies across the p-side semiconductor layer 50 and the n-side semiconductor layer 20, supplying holes and electrons to the active layer 30 to thereby allow the active layer 30 to emit light.

The active layer 30 will be described in detail below.

An active layer 30 is disposed between an n-side semiconductor layer 20 and a p-side semiconductor layer 50. The active layer 30 emits ultraviolet light. The peak emission wavelength of the ultraviolet light emitted by the active layer 30 is in a range of, for example, 220 nm to 350 nm.

The active layer 30 includes, successively from the n-side semiconductor layer 20 side, a first barrier layer 31 containing Al, a first well layer 32 containing Al and emitting ultraviolet light, a second barrier layer 33 containing Al, and a second well layer 34 containing Al and emitting ultraviolet light, for example.

The thickness of the first well layer 32 can be set, for example, in a range of 3 nm to 6 nm. The thickness of the second well layer 34 can be set, for example, in a range of 1 nm to 4 nm. The thickness of the first layer 31a of the first barrier layer 31 is, for example, in a range of 10 nm to 60 nm, and the thickness of the second layer 31b is in a range of 5 nm to 20 nm. The thickness of the second barrier layer 33 is, for example, in a range of 1 nm to 5 nm.

Specific examples of the first well layer 32, the second well layer 34, the first barrier layer 31, and the second barrier layer 33 will be explained below.

For the first well layer 32 and the second well layer 34, for example, a layer formed of AlGaN can be used. For the first barrier layer 31 and the second barrier layer 33, for example, a layer formed of AlGaN can be used. The Al composition ratio of the first well layer 32 and the second well layer 34 can be set, for example, to 10% or higher, specifically 10% to 50%, more specifically 30% to 50%. Assuming that the peak wavelength of the light from the first well layer 32 and the second well layer 34 is about 280 nm, an AlGaN layer having about 42% Al composition ratio can be used for the first well layer 32 and the second well layer 34. The Al composition ratio of the first barrier layer 31 and the second barrier layer 33 can be set, for example, to 10% or higher, specifically 10% to 70%, more specifically 30% to 70%.

In the nitride semiconductor light emitting element 1, moreover, the Al composition ratio of the second well layer 34 is set higher than that of the first well layer 32, and the thickness of the second well layer 34 is set to be less than that of the first well layer 32. This can increase the light emission efficiency of the entirety of the active layer, including the first well layer 32 and the second well layer 34, as a whole.

To describe in detail, in the second well layer 34 that is in contact with the electron blocking layer 40, the development of strain in the band structure tends to reduce the radiative recombination rate. This occasionally causes a shift between the peak wavelength of the light from the second well layer 34 and the peak wavelength of the light from the first well layer 32. In the nitride semiconductor light emitting element 1 according to this embodiment, the Al composition ratio of the second well layer 34 is set higher than that of the first well layer 32. This can reduce the difference between the band gap of the second well layer 34 and the band gap of the electron blocking layer 40 to thereby reduce the strain occurring in the band structure of the second well layer 34. This, as a result, can reduce the shift between the peak wavelength of the light from the second well layer 34 and the peak wavelength of the light from the first well layer 32, thereby increasing the emission efficiency of the active layer as a whole.

Furthermore, the second well layer 34, which is lesser in thickness than the first well layer 32, emits less light. This can reduce the emission of the light from the second well layer 34 having a peak wavelength that is shifted from the peak wavelength of the light from the first well layer 32, thereby increasing the light emission efficiency of the active layer as a whole.

In the nitride semiconductor light emitting element 1 according to this embodiment, the Al composition ratio difference between the second well layer 34 and the first well layer 32, and the thickness ratio of the second well layer 34 and the first well layer 32 are suitably set by taking into consideration the light emission efficiency of the active layer 30 as a whole and the emission wavelength shift.

For example, the thickness of the second well layer 34 is 30% to 60% of the thickness of the first well layer 32. Furthermore, the Al composition ratio difference between the second well layer 34 and the first well layer 32 is in a range of 2% to 10%, for example.

Moreover, the Al composition ratio difference between the second well layer 34 and the electron blocking layer 40 is less than the Al composition ratio difference between the first well layer 32 and the electron blocking layer 40.

Preferable embodiments of the first barrier layer 31 and the second barrier layer 33 will be explained below.

The highest n-type impurity concentration peak in the first barrier layer 31 is preferably located closer to the p-side semiconductor layer 50. This can increase the light emission efficiency in the first well layer 32. In other words, the hole trapping effect in the first well layer 32 is further improved by increasing the difference between the band gap of the first barrier layer 31 and the band gap of the first well layer 32 in the valence band by positioning the n-type impurity concentration peak in the first barrier layer 31 closer to the p-side semiconductor layer 50. This can further increase the light emission efficiency in the first well layer 32. There is a concern that doping the first barrier layer 31 with an n-type impurity could degrade the crystallinity of the first barrier layer 31. In this example, however, the barrier at the border between the first well layer 32 and the first barrier layer 31 is made higher while reducing the n-type impurity concentration in the first barrier layer 31 closer to the n-side semiconductor layer 20 by positioning the highest n-type impurity concentration peak in the first barrier layer 31 closer to the p-side semiconductor layer 50. This can reduce the crystallinity deterioration of the first barrier layer 31 as a whole. Here, the highest n-type impurity concentration peak in the first barrier layer 31 located closer to the p-side semiconductor layer 50 is, for example, 1×10¹⁹ to 6×10¹⁹/cm³. Furthermore, the lowest n-type impurity concentration in the first barrier layer 31 is located closer to the n-side semiconductor layer 20 than the highest n-type impurity concentration peak in the first barrier layer 31 is. For example, the lowest n-type impurity concentration in the first barrier layer 31 is 1×10¹⁷ to 9×10¹⁷/cm³.

Moreover, the Al composition ratio of the first barrier layer 31 is preferably higher than the Al composition ratio of the second barrier layer 33. This can increase the light emission efficiency in the first well layer 32. In other words, the number of holes injected into the first well layer 32 can be increased by making the band gap of the second barrier layer 33 smaller than the band gap of the first barrier layer 31 by making the Al composition ratio of the first barrier layer 31 higher than the Al composition ratio of the second barrier layer 33. Because the band gap of the first barrier layer 31 is larger than the band gap of the second barrier layer 33, the hole trapping effect in the first well layer 32 can be increased. The emission efficiency in the first well layer 32 is increased by this. For example, the Al composition ratio of the first barrier layer 31 is 3% to 17% larger than the Al composition ratio of the second barrier layer 33.

Specific examples and preferable examples of barrier layers and well layers in this embodiment will be described below.

For example, a first barrier layer 31 has a first layer 31a and a second layer 31b that is located closer to the p-side semiconductor layer 50 than the first layer 31a is as shown in FIG. 2. The n-type impurity concentration of the first layer 31a differs from the n-type impurity concentration of the second layer 31b. Specifically, the n-type impurity concentration of the first layer 31a is lower than the average value of n-type impurity concentration in the entirety of the first barrier layer 31, and the n-type impurity concentration of the second layer 31b is higher than the average value of n-type impurity concentration in the entirety of the first barrier layer 31. Allowing the first barrier layer 31 to have a first layer 31a and a second layer 31b having different n-type concentrations in this manner can locate the highest n-type impurity concentration in the first barrier layer 31 closer to the p-side semiconductor layer 50. The highest n-type impurity concentration peak in the first barrier layer 31 is located in the first layer 31a, and the lowest n-type impurity concentration in the first barrier layer 31 is located in the second layer 31b.

Here, the second layer 31b is preferably lesser in thickness than the first layer 31a. The n-type impurity concentration of the second layer 31b is higher than the average value of n-type impurity concentration in the entirety of the first barrier layer 31. Thus, reducing the thickness of the second layer 31b having a relatively high n-type impurity concentration can reduce the crystallinity deterioration of the first barrier layer 31 attributable to a thick layer having a high n-type impurity concentration, thereby improving the emission efficiency. For example, the thickness of the second layer 31b is preferably 5% to 30% of the thickness of the entirety of the first barrier layer 31. This can reduce the crystallinity deterioration of the first barrier layer 31 while improving the hole trapping effect in the first well layer 32.

Moreover, the second barrier layer 33 is preferably lesser in thickness than the second layer 31b. This can increase the supply of holes to the first well layer 32.

The second barrier layer 33 may be undoped, or contain an n-type impurity. Employing an undoped second barrier layer 33 can reduce the crystallinity deterioration of the active layer 30. Allowing the second barrier layer 33 to contain an n-type impurity can reduce the electrical resistance of the second barrier layer 33 to thereby reduce the forward voltage. When the second barrier layer 33 contains an n-type impurity, the n-type impurity concentration of the second barrier layer 33 is preferably lower than the n-type impurity concentration of the second layer 31b and higher than the n-type impurity concentration of the first layer 31a. This can reduce the forward voltage while reducing the crystallinity deterioration of the second barrier layer 33.

Furthermore, the Al composition ratio of the first layer 31a and the Al composition ratio of the second layer 31b are preferably substantially the same. This can reduce the band gap difference attributable to the difference between the Al composition ratio of the first layer 31a and that of the second layer 31b, allowing electrons to be supplied to the first well layer 32 efficiently.

Moreover, the first barrier layer 31 is preferably in contact with the n-side semiconductor layer 20, and the Al composition ratio of the first barrier layer 31 is preferably substantially the same as the Al composition ratio of the n-side semiconductor layer 20. This can reduce the band gap difference attributable to the Al composition ratio difference between the n-side semiconductor layer 20 and the first barrier layer 31, thereby allowing electrons to be supplied to the first well layer 32 efficiently.

In the case in which the n-side semiconductor layer 20 includes an n-side contact layer 22, and the first barrier layer 31 is in contact with the n-side contact layer 22, the n-type impurity concentration of the n-side contact layer 22 is preferably lower than n-type impurity concentration of the second layer 31b and higher than the n-type impurity concentration of the first layer 31a. This can reduce the resistance of the n-side contact layer 22 while reducing the crystallinity deterioration of the n-side contact layer 22.

As described above, the second well layer 34 is preferably lesser in thickness than the first well layer 32. This can increase the supply of holes to the first well layer 32.

As described above, the Al composition ratio of the second well layer 34 is higher than the Al composition ratio of the first well layer 32. The Al composition ratio of the second well layer 34 can be in a range of 2% to 10% larger than the Al composition ratio of the first well layer 32.

Specific examples and preferable examples of barrier layers and well layers have been described above. The thickness and the Al composition ratio of and the amount of an n-type impurity added to the first layer 31a and second layer 31b of the first barrier layer 31 and the second barrier layer 33 can be suitably adjusted based on the aimed specifications, such as the emission wavelength, light emission output, drive voltage, current, and the like, by taking into consideration the specific examples and preferable examples described above. Similarly, the thickness and the Al composition ratio of and the amount of an n-type impurity added to the first well layer 32 and the second well layer 34 can also be suitably adjusted by taking into consideration the specific examples and preferable examples described above.

With respect to this embodiment, as shown in FIG. 2, a specific example in which barrier layers and well layers each included two layers have been described, but the present invention is not limited to this. For example, one, two, or more barrier layers and well layers may be disposed between the first well layer 32 and the second well layer 34.

A method of manufacturing a nitride semiconductor light emitting element according to this embodiment will be explained below with reference to FIG. 3 to FIG. 8.

A method of manufacturing a nitride semiconductor light emitting element according to this embodiment includes:
(S1) forming an n-side semiconductor layer;
(S2) forming an active layer above the n-side semiconductor layer; and
(S3) forming a p-side semiconductor layer above the active layer,
the step of forming the active layer (S2) including:
(S2-1) forming above the n-side semiconductor layer a first barrier layer containing Al;
(S2-2) forming above the first barrier layer a first well layer that contains Al and emits ultraviolet light;
(S2-3) forming above the first well layer a second barrier layer containing Al, and
(S2-4) forming above the second barrier layer a second well layer that contains Al at a higher composition ratio than a Al composition ratio of the first well layer, has a thickness less than a thickness of the first well layer, and emits ultraviolet light, and
(S4) forming an electron blocking layer in contact with the second well layer between the step of forming the active layer and the step of forming the p-side semiconductor layer, wherein
the step of forming above the n-side semiconductor layer a first barrier layer (S2-1) may include
(S2-1-1) forming above the n-side semiconductor layer a first layer containing Al and an n-type impurity, and
(S2-1-2) forming above the first layer a second layer containing Al at an n-type impurity concentration higher than an n-type impurity concentration of the first layer.

Furthermore, in the case in which the step of forming a first barrier layer (S2-1) includes forming a first layer and a second layer, the step of forming the second barrier layer (S2-3) is preferably a step of forming the second barrier layer containing Al and an n-type impurity, wherein an Al composition ratio of the second barrier layer is lower than each of the Al composition ratio of the first layer and the Al composition ratio of the second layer.

The description below will include the preferable examples described above, but the preferable examples are optional and not essential.

First, as shown in FIG. 3, an underlayer 11 formed of AlN is formed above C-plane of a substrate 10 formed of sapphire, for example. The underlayer 11 is formed, for example, by MOCVD (metalorganic chemical vapor deposition), sputtering, or the like. Here, the step of forming an under layer 11 may include a step of forming the under layer 11 including a buffer layer. For example, an underlayer 11 including a butter layer is formed by forming an AlN buffer layer by sputtering, and then forming above the buffer layer an AlN layer by MOCVD or the like.

Each of the semiconductor layers described later can be epitaxially grown by MOCVD, for example.

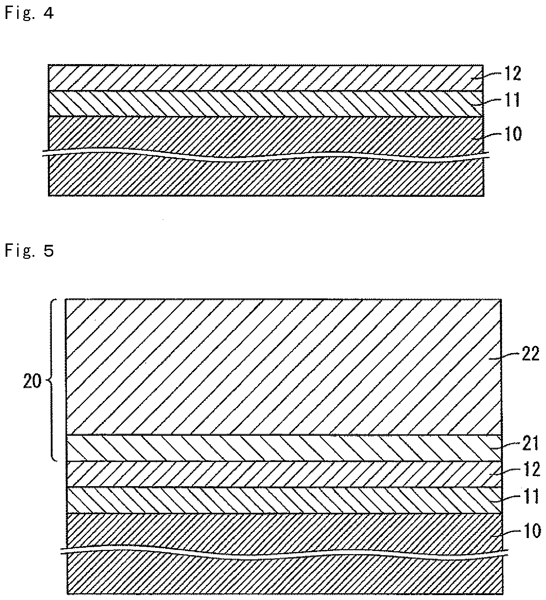

Then as shown in FIG. 4, above the underlayer 11, a superlattice layer 12 is formed. The superlattice layer 12 is formed by alternately growing first semiconductor layers and second semiconductor layers having a different lattice constant from that of the first semiconductor layers. The first semiconductor layers are formed by growing AlN layers by using a trimethyl aluminum (TMA) gas and ammonia gas as the source gases, and primarily hydrogen (H₂) gas as the carrier gas, for example. The second semiconductor layers are formed by growing AlGaN layers by using as the source gases a TMA gas, a trimethyl gallium (TMG) gas, and ammonia gas, and primarily hydrogen gas as the carrier gas. Each layer of the superlattice layer 12 can be formed by setting the temperature in a range of 1000°C to 1250°C, for example.

Then as shown in FIG. 5, above the superlattice layer 12, an n-side semiconductor layer 20 that includes an undoped layer 21 and an n-side contact layer 22 is formed. The undoped layer 21 is formed by growing an AlGaN layer by using as the source gases a TMA gas, TMG gas, and ammonia gas, and primarily hydrogen gas as the carrier gas. The n-side contact layer 22 is formed by growing an AlGaN layer containing an n-type impurity by using as the source gases a TMA gas, TMG gas, and ammonia gas, a monosilane (SiH₄) gas as the n-type impurity gas, and primarily hydrogen gas as the carrier gas. Each layer of the n-side semiconductor layer 20 can be formed by setting the temperature in a range of 1000°C to 1250°C, for example.

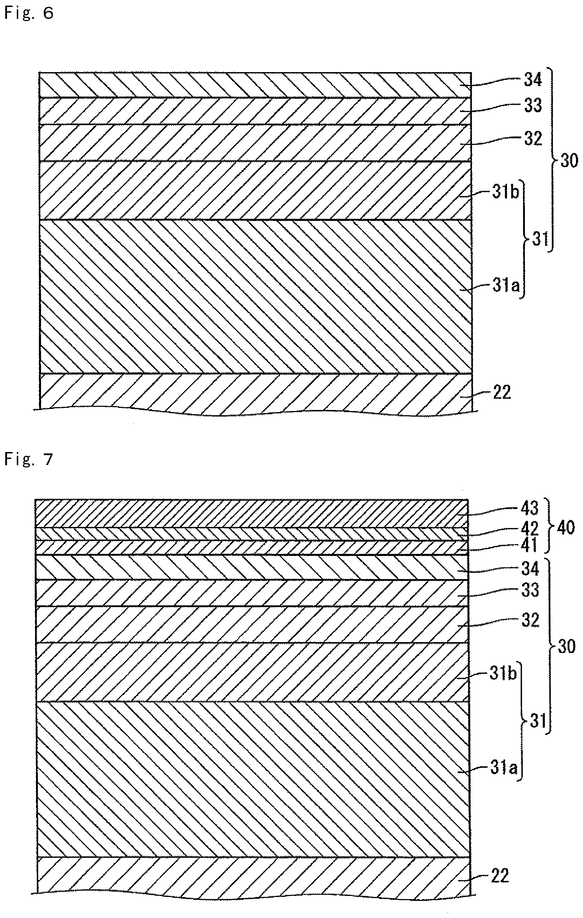

Then as shown in FIG. 6, an active layer 30 is formed above the n-side contact layer 22.

Specifically, above the n-side contact layer 22, a first barrier layer 31 containing Al is formed. The first barrier layer 31 is formed by growing an AlGaN layer containing Si as an n-type impurity, or an undoped AlGaN layer by using as the source gases a TMA gas, TEGa gas, and ammonia gas, a monosilane (SiH₄) gas as the n-type impurity gas as needed, and primarily nitrogen gas as the carrier gas, for example.

Then above the first barrier layer 31 a first well layer 32 containing Al and emitting ultraviolet light is formed. The first well layer 32 is formed, for example, by growing an AlGaN layer by using as the source gases a TMA gas, TEGa gas, and ammonia gas, and primarily nitrogen gas as the carrier gas.

Then above the first well layer 32 a second barrier layer 33 containing Al is formed. The second barrier layer 33 is formed, the same as or similar to the first barrier layer 31, by growing an AlGaN layer containing Si which is an n-type impurity or undoped AlGaN layer by using as the source gases a TMA gas, TEGa gas, and ammonia gas, a monosilane (SiH₄) gas as the n-type impurity gas as needed, and primarily nitrogen gas as the carrier gas, for example.

Then above the second barrier layer 33 a second well layer 34 emitting ultraviolet light, having a thickness less than that of the first well layer 32, and containing Al at a higher composition ratio than an Al composition ratio of the first well layer 32 is formed.

For the second well layer 34, the same or similar source and carrier gases to those used for the first well layer 32 can be used. The second well layer is grown, for example, in a shorter time than the first well layer 32 by increasing the percentage of the TMA gas. This can form a second well layer 34 lesser in thickness than the first well layer 32 and containing Al at a higher composition ratio than that of the first well layer 32.

In the case of forming a first barrier layer 31 to include a first layer 31a and a second layer 31b containing a higher concentration n-type impurity than the first layer 31a, the layers can be formed as follows, for example.

First, by using as the source gases a TMA gas, TEGa gas, and ammonia gas, a monosilane (SiH₄) gas as the n-type impurity gas, and primarily nitrogen gas as the carrier gas, for example, a first layer containing Al and an n-type impurity is formed above the n-side semiconductor layer.

Then by increasing the flow rate of the monosilane (SiH₄) gas, a second layer containing Al and a higher concentration n-type impurity than the first layer is formed above the first layer.

Then as shown in FIG. 7, above the active layer 30, an electron blocking layer 40 having a larger band gap than the first well layer 32 and the second well layer 34 is formed in contact with the second well layer 34. The electron blocking layer 40 is formed to include a first electron blocking layer 41 which is an AlN layer, a second electron blocking layer 42 which is a first AlGaN layer, and a third electron blocking layer 43 which is a second AlGaN layer. The first electron blocking layer 41 is formed by using as the source gases a TMA gas and ammonia gas, and primarily nitrogen gas as the carrier gas, for example. The second electron blocking layer 42 is formed by using as the source gases a TMA gas, TEGa gas, and ammonia gas, and nitrogen gas as the carrier gas, for example. The third electron blocking layer 43 is formed by using as the source gases a TMA gas, TEGa gas, and ammonia gas, and primarily nitrogen gas as the carrier gas, for example. For example, in forming the third electron blocking layer 43, the flow ratio of the TMA gas which is the Al source gas is set higher than that in forming the second electron blocking layer 42. This can form the third electron blocking layer 43 to have a higher Al composition ratio than that of the second electron blocking layer 42. Each layer of the electron blocking layer 40 can be formed by setting the temperature in a range of 750°C to 950°C, for example.

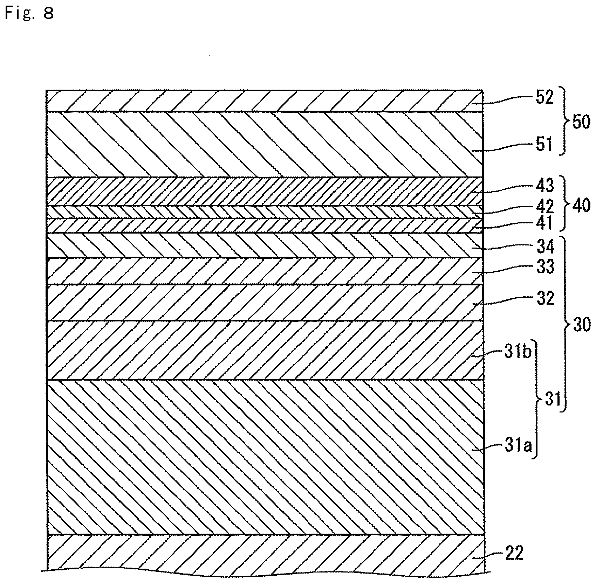

Then as shown in FIG. 8,a p-side semiconductor layer 50 is formed above the electron blocking layer 40. The p-side semiconductor layer 50 is formed by growing successively from the active layer 30 side a first p-side semiconductor layer 51 and a second p-side semiconductor layer 52. The first p-side semiconductor layer 51 is formed by growing an AlGaN layer containing Mg as a P-type impurity by using as the source gases a TMA gas, TEGa gas, and ammonia gas, and a bis(cyclopentadienyl)magnesium (Cp₂Mg) gas as the p-type impurity gas. The second p-side semiconductor layer 52 is formed by growing, for example, an AlGaN layer containing Mg as a p-type impurity by using as the source gases a TMA gas, TMG gas, and ammonia gas, and a bis(cyclopentadienyl)magnesium (Cp₂Mg) gas as the p-type impurity gas, or a GaN layer containing Mg as a p-type impurity by using as source gases a TMG gas and ammonia gas (no TMA gas), and a bis(cyclopentadienyl)magnesium (Cp₂Mg) gas as the p-type impurity gas.

Each layer of the p-side semiconductor layer 50 can be formed by setting the temperature in a range of 750°C to 950°C, for example.

Subsequent to forming the p-side semiconductor layer 50, a portion of the p-side semiconductor layer 50, a portion of the electron blocking layer 40, and a portion of the active layer 30 are removed to expose a portion of the n-side contact layer 22.

Then as shown in FIG. 1 an n-electrode 60 is formed above the exposed n-side contact layer 22, and a p-electrode 70 is formed above the third layer 53 of the p-side semiconductor layer 50.

By following the steps described above, a nitride semiconductor light emitting element according to this embodiment can be manufactured.

A specific form of a nitride semiconductor light emitting element according to this embodiment will be described below.

### EXAMPLE

As the substrate 10, a sapphire substrate having C-plane as a principal plane was used. An underlayer 11 formed of AlN was formed above the substrate 10 to a thickness of about 2.1 *µ*m.

The temperature was then set at 1175°C, and an Al_{0.60}Ga_{0.40}N layer was formed above the underlayer 11 to a thickness of about 21 nm by using TMA gas, TMG gas, and ammonia gas as source gases. This was followed by forming an AlN layer at 1175°C to a thickness of about 10 nm by using TMA gas and ammonia gas as source gases. A superlattice layer 12 was formed by stacking 30 pairs of such AlGaN and AlN layers.

Then at 1175°C, an undoped layer 21 was formed above the superlattice layer 12 by growing Al_{0.60}Ga_{0.40}N to a thickness of about 0.5 *µ*m by using TMA gas, TMG gas, and ammonia gas as source gases. This was followed by forming an n-side contact layer 22 at 1175°C by growing Al_{0.60}Ga_{0.40}N containing an n-type impurity to a thickness of about 2.2*µ*m by using TMA gas, TMG gas, ammonia gas, and SiH₄ gas as source gases. An n-side semiconductor layer 20 including such an undoped layer 21 and an n-side contact layer 22 was formed. The n-type impurity concentration of the n-side contact layer 22 was about 9.5×10¹⁸/cm³.

Subsequently, the temperature was set at 950°C and a first layer 31a was formed above the n-side semiconductor layer 20 by growing Al_{0.60}Ga_{0.40}N containing an n-type impurity to a thickness of about 40 nm by using TMA gas, TMG gas, ammonia gas, and SiH₄ gas as source gases. This was followed by forming a second layer 31b at 950°C by growing Al_{0.60}Ga_{0.40}N to a thickness of about 10 nm by using TMA gas, TMG gas, ammonia gas, and SiH₄ gas as source gases. Here, the flow rates of the source gases for forming the first layer 31a were set to: TMA gas 16 sccm, TEGa gas 45 sccm, ammonia gas 10 slm, and SiH₄ gas 0.5 sccm. The flow rates of the source gases for forming the second layer 31b were set to: TMA gas 16 sccm, TEGa gas 45 sccm, ammonia gas 10 slm, and SiH₄ gas 16 sccm.

In the manner described above, a first barrier layer 31 which included a first layer 31a containing an n-type impurity and a second layer 31b containing more n-type impurity than that in the first layer 31a was formed.

Furthermore, the thicknesses of the first layer 31a and the second layer 31b here are the thicknesses in the manufacturing process, and do not necessarily match the thickness of the first layer 31a having a lower n-type impurity concentration than the average value of that of the entire first barrier layer 31 and the thickness of the second layer 31b having a higher n-type impurity concentration than the average value of that of the entire first barrier layer 31 identified after manufacturing the product.

Then a first well layer 32 was formed at 950°C by growing Al_{0.43}Ga_{0.57}N to a thickness of about 4.4 nm by using TMA gas, TEGa gas, and ammonia gas as source gases.

Subsequently, a second barrier layer 33 was formed by setting the temperature at 950°C and growing Al_{0.53}Ga_{0.47}N to a thickness of about 2.5 nm by using TMA gas, TEGa gas, and ammonia gas as source gases. This was followed by forming a second well layer 34 by growing Al_{0.47}Ga_{0.53}N to a thickness of about 2.2 nm at 950°C by using TMA gas, TEGa gas, and ammonia gas as source gases. In this manner, an active layer 30 which included two well layers and two barrier layers was formed.

Subsequently, the temperature was set at 870°C, and a first electron blocking layer 41 which was an AlN layer was formed above the active layer 30 to a thickness of about 1.3 nm by using TMA gas and ammonia gas as source gases. This was followed by forming a second electron blocking layer 42 which was a first AlGaN layer at 870°C by growing Al_{0.55}Ga_{0.45}N to a thickness of about 1.2 nm by using TMA gas, TEGa gas, and ammonia gas as source gases. This was followed by forming a third electron blocking layer 43 which was a second AlGaN layer at 870°C by growing Al_{0.78}Ga_{0.22}N to a thickness of about 4 nm by using TMA gas, TEGa gas, and ammonia gas as source gases. In this manner, an electron blocking layer 40 which included an AlN layer and two AlGaN layers was formed.

Then the temperature was set at 870°C, and an Al_{0.63}Ga_{0.37}N layer containing a p-type impurity was formed above the electron blocking layer 40 to a thickness of about 75 nm by using TMA gas, TEGa gas, ammonia gas, and Cp₂Mg gas as source gases. This was followed by forming an Al_{0.53}Ga_{0.47}N layer containing a p-type impurity at 870°C to a thickness of about 27 nm by using TMA gas, TMG gas, ammonia gas, and Cp₂Mg gas as source gases. Then a gradient composition layer containing a p-type impurity was formed at 870°C to a thickness of about 3 nm by using TMA gas, TEGa gas, ammonia gas, and Cp₂Mg gas as source gases while gradually reducing the TMA gas such that the Al composition ratio gradually decreased from Al_{0.53}Ga_{0.47}N to ultimately 0. In the manner described above, a first p-side semiconductor layer 51 was formed.

This was followed by forming an Al_{0.40}Ga_{0.60}N layer containing a p-type impurity at 900°C to a thickness of about 10 nm by using TMA gas, TMG gas, ammonia gas, and Cp2Mg gas as source gases. Then a GaN layer containing a p-type impurity was formed at 900°C to a thickness of about 10 nm by using TMA gas, TMG gas, and ammonia gas as source gases. In the manner described above, a second p-side semiconductor layer 52 that included an Al_{0.40}Ga_{0.60}N layer containing a p-type impurity and a GaN layer containing a p-type impurity was formed.

Subsequent to forming each semiconductor layer, a heat treatment was conducted in a nitrogen atmosphere in the reaction chamber at a temperature of about 475°C.

Subsequent to the heat treatment, a portion of the p-side semiconductor layer 50 and a portion of the active layer 30 were removed to expose a portion of the n-side contact layer 22.

Then an n-electrode 60 was formed above the n-side contact layer 22, and a p-electrode 70 was formed above the p-side semiconductor layer 50. For the n-electrode 60, a multilayer structured electrode in which a Ti layer, AlSi layer, a Ta layer, a Ru layer, and a Ti layer were stacked successively from the n-side contact layer 22 side was used. For the p-electrode 70, a multilayer structured electrode in which a Ti layer, a Ru layer, and a Ti layer were stacked successively from the third layer 53 side was used.

The forward volage of the nitride semiconductor light emitting element prepared as described above was 5.16 V, and the light emission output Po was 172 mW. The forward volage and the light emission output Po shown here are the values achieved when a 350 mA current was applied.

The position of the highest n-type impurity concentration peak in the first barrier layer 31 was in the second layer 31b. The highest peak value of the n-type impurity concentration in the first barrier layer 31 was about 3×10¹⁹/cm³.

The nitride semiconductor light emitting element according to the embodiments of the present disclosure includes the following.

## Claims

1. A nitride semiconductor light emitting element comprising:
an n-side semiconductor layer;
a p-side semiconductor layer;
an active layer positioned between the n-side semiconductor layer and the p-side semiconductor layer; and
an electron blocking layer positioned between the p-side semiconductor layer and the active layer; wherein:
the active layer comprises, successively from the n-side semiconductor layer side:
a first barrier layer containing Al,
a first well layer that contains Al and emits ultraviolet light,
a second barrier layer containing Al, and
a second well layer that is in contact with the electron blocking layer, contains Al, and emits ultraviolet light;
an Al composition ratio of the second well layer is higher than an Al composition ratio of the first well layer; and
a thickness of the second well layer is less than a thickness of the first well layer.

2. The nitride semiconductor light emitting element according to claim 1 wherein the thickness of the second well layer is in a range of 30% to 60% of the thickness of the first well layer.

3. The nitride semiconductor light emitting element according to claim 1 or 2 wherein:
a difference between the Al composition ratio of the first well layer and the Al composition ratio of the second well layer is in a range of 2% to 10%.

4. The nitride semiconductor light emitting element according to any one of claims 1 to 3, wherein:
the first barrier layer contains an n-type impurity, and
a highest n-type impurity concentration peak in the first barrier layer is located in a portion of the first barrier layer that is closer to the p-side semiconductor layer than to the n-side semiconductor layer.

5. The nitride semiconductor light emitting element according to any one of claims 1 to 4 wherein:
an Al composition ratio of the first barrier layer is higher than an Al composition ratio of the second barrier layer.

6. The nitride semiconductor light emitting element according to any one of claims 1 to 5 wherein:
the first barrier layer comprises:
a first layer containing an n-type impurity at a concentration lower than an average value of n-type impurity concentration in an entirety of the first barrier layer, and
a second layer located closer to the p-type semiconductor layer than the first layer and containing an n-type impurity at a concentration higher than the average value of n-type impurity concentration in the entirety of the first barrier layer.

7. The nitride semiconductor light emitting element according to claim 6, wherein:
a thickness of the first layer is greater than a thickness of the second layer,
or wherein:
a thickness of the second layer is in a range of 5% to 30% of a thickness of the first barrier layer,
or wherein:
a thickness of the second barrier layer is less than a thickness of the second layer,
or wherein:
the second barrier layer contains an n-type impurity, and
an n-type impurity concentration of the second barrier layer is lower than the n-type impurity concentration of the second layer and higher than the n-type impurity concentration of the first layer,
or wherein:
an n-type impurity concentration of the n-side semiconductor layer is lower than the n-type impurity concentration of the second layer, and is higher than the n-type impurity concentration of the first layer.

8. The nitride semiconductor light emitting element according to any one of claims 1 to 7 wherein:
an Al composition ratio of the first barrier layer and an Al composition ratio of the n-side semiconductor layer are substantially the same.

9. A method of manufacturing a nitride semiconductor light emitting element, the method comprising:
forming an n-side semiconductor layer;
forming an active layer above the n-side semiconductor layer by performing steps comprising:
forming, above the n-side semiconductor layer, a first barrier layer containing Al,
forming, above the first barrier layer, a first well layer that contains Al and emits ultraviolet light,
forming, above the first well layer, a second barrier layer containing Al, and
forming, above the second barrier layer, a second well layer that contains Al and emits ultraviolet light, wherein an Al composition ratio of the second well layer is higher than an Al composition ratio of the first well layer, and a thickness of the second well layer is less than a thickness of the first well layer;
subsequently, forming an electron blocking layer in contact with the second well layer; and
subsequently, forming a p-side semiconductor layer above the active layer.

10. The method of manufacturing a nitride semiconductor light emitting element according to claim 9, wherein:
the thickness of the second well layer is 30% to 60% of the thickness of the first well layer.

11. The method of manufacturing a nitride semiconductor light emitting element according to claim 9 or 10, wherein:
a difference between the Al composition ratio of the first well layer and the Al composition ratio of the second well layer is in a range of 2% to 10%..

12. The method of manufacturing a nitride semiconductor light emitting element according to any one of claims 9 to 11, wherein:
the first barrier layer contains an n-type impurity, and
a highest n-type impurity concentration peak in the first barrier layer is located in a portion of the first barrier layer that is closer to the p-side semiconductor layer than to the n-side semiconductor layer.

13. The method of manufacturing a nitride semiconductor light emitting element according to any one of claims 9 to 12, wherein:
an Al composition ratio of the first barrier layer is higher than an Al composition ratio of the second barrier layer.

14. The method of manufacturing a nitride semiconductor light emitting element according to any one of claims 9 to 13, wherein:
the step of forming the first barrier layer comprises:
forming a first layer containing an n-type impurity, and
forming a second layer that is located closer to the p-side semiconductor layer than the first layer and contains an n-type impurity at a higher concentration than an n-type impurity in the first layer.

15. The method of manufacturing a nitride semiconductor light emitting element according to claim 14, wherein:
a thickness of the second layer is less than a thickness of the first layer,
or wherein:
a thickness of the second layer is in a range of 5% to 30% of a thickness of the first barrier layer,
or wherein:
a thickness of the second barrier layer is less than a thickness of the second layer,
or wherein:
an n-type impurity concentration of the first layer is lower than an n-type impurity concentration of the n-side semiconductor layer; and
an n-type impurity concentration of the second layer is higher than the n-type impurity concentration of the n-side semiconductor layer.

16. The method of manufacturing a nitride semiconductor light emitting element according to any one of claims 9 to 15, wherein:
an Al composition ratio of the first barrier layer and an Al composition ratio of the n-side semiconductor layer are substantially the same.
